# EUROPÄISCHE PATENTSCHRIFT

(11) **EP 3 850 419 B1**
(45) Veröffentlichungstag und Bekanntmachung des Hinweises auf die Patenterteilung: **11.10.2023**
(21) Anmeldenummer: 19759520.0
(22) Anmeldetag: 20.08.2019
(51) Int. Cl.: G02B 26/08, H10N 30/20

(54) **MIKROMECHANISCHES BAUTEIL UND HERSTELLUNGSVERFAHREN FÜR EIN MIKROMECHANISCHES BAUTEIL**
MICROMECHANICAL COMPONENT AND METHOD FOR PRODUCING A MICROMECHANICAL COMPONENT
COMPOSANT MICROMÉCANIQUE ET PROCÉDÉ DE FABRICATION D'UN COMPOSANT MICROMÉCANIQUE

(30) Priorität: 12.09.2018 DE 102018215528
(43) Veröffentlichungstag der Anmeldung: 21.07.2021
(73) Patentinhaber: Robert Bosch GmbH, 70442 Stuttgart (DE)
(72) Erfinder: SCHARY, Timo, 72631 Aichtal-Neuenhaus (DE); BOESSENDOERFER, Ralf, 91550 Dinkelsbuehl (DE); DOESSEL, Kerrin, 70193 Stuttgart (DE); MIHALJEVIC, Josip, 71088 Holzgerlingen (DE); MUCHOW, Joerg, 81477 Muenchen (DE); SCHATZ, Frank, 70806 Kornwestheim (DE); RIEDRICH-MOELLER, Janine, 71229 Leonberg-Warmbronn (DE); EBERSPAECHER, Alexander, 73434 Aalen (DE)
(86) Internationale Anmeldenummer: PCT/EP2019/072217
(87) Internationale Veröffentlichungsnummer: WO 2020/052919

(56) Entgegenhaltungen:
- EP-A1- 2 781 948
- US-A1- 2013 063 800
- US-A1- 2018 172 982

## Beschreibung

Die Erfindung betrifft ein mikromechanisches Bauteil. Ebenso betrifft die Erfindung ein Herstellungsverfahren für ein mikromechanisches Bauteil.

### Stand der Technik

In der JP 2009-223165 A ist ein verstellbarer Mikrospiegel beschrieben, welcher mittels zweier mäanderförmiger Federn mit Teilabschnitten, die jeweils mit mindestens einem piezoelektrischen Material abgedeckt sind, in Bezug zu einer Halterung des verstellbaren Mikrospiegels verstellbar sein soll. Insbesondere soll durch Anlegen mindestens einer Spannung an das mindestens eine piezoelektrische Material abwechselnd eine Biege- oder Zugspannung auf die Teilabschnitte der beiden mäanderförmigen Federn so ausbildbar sein, dass der verstellbare Mikrospiegel mittels einer bewirkten spiegelsymmetrischen Verformung der beiden mäanderförmigen Federn in Bezug zu seiner Halterung verstellt wird.

US 2013/063800 A1 offenbart ein mikromechanisches Bauteil mit einer rahmenförmigen Halterung, zwei mäanderförmigen Federn mit piezoelektrischen Aktoren und zwei Torsionsfedern, die über Trägerabschnitte mit der rahmenförmigen Halterung indirekt verbunden sind.

US 2018/172982 A1 offenbart ein mikromechanisches Bauteil mit einer rahmenförmigen Halterung und vier mäanderförmigen Federn mit piezoelektrischen Elementen.

EP 2 781 948 A1 offenbart ein mikromechanisches Bauteil mit einer rahmenförmigen Halterung und zwei mäanderförmigen Federn mit piezoelektrischen Aktoren.

### Offenbarung der Erfindung

Die Erfindung schafft ein mikromechanisches Bauteil mit den Merkmalen des Anspruchs 1 und ein Herstellungsverfahren für ein mikromechanisches Bauteil mit den Merkmalen des Anspruchs 8.

### Vorteile der Erfindung

### Vorteile der Erfindung

Die vorliegende Erfindung schafft mikromechanische Bauteile mit jeweils einem verstellbaren Teil, welches gezielt um die mittels der Ausbildung der zwei Torsionsfedern festgelegte Drehachse verstellbar ist, wobei ein Auftreten von weiteren unerwünschten Verstellbewegungen des verstellbaren Teils, d. h. ein Auftreten von sogenannten Störmoden, mittels der zwei Torsionsfedern reduziert/verhindert ist. Bei einem Betrieb eines derartigen mikromechanischen Bauteils ist deshalb eine Häufigkeit der Anregung von Störmoden gegenüber dem Stand der Technik signifikant reduziert.

Wie unten genauer erläutert wird, wirken die zwei Torsionsfedern insbesondere einem "Herausheben" des verstellbaren Teils aus einer Ebene der zwei Torsionsfedern, bzw. einer Störmode des verstellbaren Teils senkrecht zu der Drehachse, entgegen. Die vorliegende Erfindung schafft damit mikromechanische Bauteile mit einem gegenüber dem Stand der Technik verbesserten Betrieb. Zusätzlich gewährleistet die vorliegende Erfindung diesen Vorteil der mikromechanischen Bauteile bei vergleichsweise geringen Herstellungskosten der mikromechanischen Bauteile.

Erfindungsgemäß umfasst das mikromechanische Bauteil zumindest eine Sensoreinrichtung, welche dazu ausgelegt ist, mindestens ein zu einer Auslenkung des verstellbaren Teils aus seiner Ruhestellung in Bezug zu der Halterung korrespondierendes Sensorsignal auszugeben oder bereitzustellen, wobei die Sensoreinrichtung über mindestens eine an und/oder in der ersten Torsionsfeder und/oder der zweiten Torsionsfeder ausgebildete Signalleitung mit einer auf der Halterung ausgebildeten Auswerteelektronik oder einem auf der Halterung ausgebildeten Auswerteelektronik-Anwendungskontakt verbunden ist. Für eine elektrische Kontaktierung der Sensoreinrichtung kann somit auf eine an und/oder in den mindestens zwei mäanderförmigen Federn ausgebildete Signalleitung gemäß dem Stand der Technik verzichtet werden. Die elektrische Kontaktierung der Sensoreinrichtung ist somit mit keinen Nebeneffekten auf eine gewünschte gute Verbiegbarkeit der mindestens zwei mäanderförmigen Federn verbunden.

Vorzugsweise umfassen die erste Aktoreinrichtung und die zweite Aktoreinrichtung jeweils mehrere piezoelektrische Aktorschichten aus mindestens einem piezoelektrischen Material, welche an und/oder in mehreren Teilabschnitten der zugeordneten mäanderförmigen Feder ausgebildet sind, und jeweils mindestens eine elektrische Leitung, welche an und/oder in der zugeordneten mäanderförmigen Feder ausgebildet ist, so, dass mindestens ein Spannungssignal an die piezoelektrischen Aktorschichten der ersten mäanderförmigen Feder und der zweiten mäanderförmigen Feder derart anlegbar ist, dass die periodischen und spiegelsymmetrischen Verformungen der ersten mäanderförmigen Feder und der zweiten mäanderförmigen Feder bewirkbar sind. Auf diese Weise können die mit piezoelektrischen Aktorschichten ausgebildeten Teilabschnitte der ersten mäanderförmigen Feder und der zweiten mäanderförmigen Feder so verbogen werden, dass das verstellbare Teil um einen relativ hohen Verstellwinkel aus seiner Ruhestellung in Bezug zu der Halterung um die Drehachse verstellt wird.

In einer vorteilhaften Ausführungsform des mikromechanischen Bauteils sind jeweils zwei benachbarte mit piezoelektrischen Aktorschichten ausgebildete Teilabschnitte der ersten mäanderförmigen Feder über je einen Zwischenabschnitt der ersten mäanderförmigen Feder und jeweils zwei benachbarte mit piezoelektrischen Aktorschichten ausgebildete Teilabschnitte der zweiten mäanderförmigen Feder über je einen Zwischenabschnitt der zweiten mäanderförmigen Feder miteinander verbunden, wobei mindestens einer der Zwischenabschnitte der ersten mäanderförmigen Feder über je ein Stegelement mit dem dazu bezüglich der ersten Symmetrieebene spiegelsymmetrischen Zwischenabschnitt der zweiten mäanderförmigen Feder verbunden ist. Das mindestens eine Stegelement des mikromechanischen Bauteils trägt in diesem Fall zur zusätzlichen Unterdrückung von Störmoden bei.

Alternativ oder ergänzend können die mit piezoelektrischen Aktorschichten ausgebildeten Teilabschnitte der ersten mäanderförmigen Feder und mit piezoelektrischen Aktorschichten ausgebildeten Teilabschnitte der zweiten mäanderförmigen Feder parallel zueinander und senkrecht zu der Drehachse ausgerichtet sein. Ein konkaves und konvexes Verformen der Teilabschnitte derart, dass benachbart zu einem konkav verformten Teilabschnitt mindestens ein konvex verformter Teilabschnitt und benachbart zu einem konvex verformten Teilabschnitt mindestens ein konkav verformter Teilabschnitt liegt, bewirkt in diesem Fall ein Drehen des verstellbaren Teils um die Drehachse.

Als vorteilhafte Weiterbildung können mindestens zwei benachbarte mit piezoelektrischen Aktorschichten ausgebildete Teilabschnitte der ersten mäanderförmigen Feder und mindestens zwei benachbarte mit piezoelektrischen Aktorschichten ausgebildete Teilabschnitte der zweiten mäanderförmigen Feder über je ein Zwischenfederelement miteinander verbunden sein. Auch die mindestens zwei Zwischenfederelemente tragen in diesem Fall zur Unterdrückung von Störmoden bei einem Betrieb des mikromechanischen Bauteils bei.

Als weitere vorteilhafte Weiterbildung kann das mikromechanische Bauteil zusätzlich noch eine dritte mäanderförmige Feder und eine bezüglich der ersten Symmetrieebene spiegelsymmetrisch zu der dritten mäanderförmigen Feder ausgebildete vierte mäanderförmige Feder, welche an je einem äußeren Ende der jeweiligen mäanderförmigen Feder direkt oder indirekt an der Halterung und an je einem inneren Ende der jeweiligen mäanderförmigen Feder direkt oder indirekt an dem verstellbaren Teil angebunden sind, umfassen. Vorzugsweise sind an und/oder in der dritten mäanderförmigen Feder eine dritte Aktoreinrichtung und an und/oder in der vierten mäanderförmigen Feder eine vierte Aktoreinrichtung derart ausgebildet, dass mittels der dritten Aktoreinrichtung und der vierten Aktoreinrichtung periodische und bezüglich der ersten Symmetrieebene spiegelsymmetrische Verformungen der dritten mäanderförmigen Feder und der vierten mäanderförmigen Feder anregbar sind, welche gegenphasig zu den periodischen und spiegelsymmetrischen Verformungen der ersten mäanderförmigen Feder und der zweiten mäanderförmigen Feder sind. Über die bei dieser Ausführungsform des mikromechanischen Bauteil vorliegenden vier mäanderförmigen Federn können vergleichsweise hohe Verstellkräfte problemlos auf das verstellbare Teil ausgeübt werden.

Bevorzugter Weise sind die dritte mäanderförmige Feder und die vierte mäanderförmige Feder bezüglich einer senkrecht zu der ersten Symmetrieebene ausgerichteten zweiten Symmetrieebene spiegelsymmetrisch zu der ersten mäanderförmigen Feder und der zweiten mäanderförmigen Feder, wobei die Drehachse innerhalb der zweiten Symmetrieebene liegt. Eine derartige symmetrische Ausbildung der vier mäanderförmigen Federn wirkt einem Auftreten von Störmoden vorteilhaft entgegen.

Die vorausgehend beschriebenen Vorteile sind auch gewährleistet bei einem Ausführen eines korrespondierenden Herstellungsverfahrens für ein derartiges mikromechanisches Bauteil. Es wird ausdrücklich darauf hingewiesen, dass das Herstellungsverfahren so weitergebildet werden kann, dass alle oben erläuterten mikromechanischen Bauteile damit hergestellt werden können.

### Kurze Beschreibung der Zeichnungen

Weitere Merkmale und Vorteile der vorliegenden Erfindung werden nachfolgend anhand der Figuren erläutert. Es zeigen:
- Fig. 1: eine schematische Gesamtdarstellung einer ersten Ausführungsform des mikromechanischen Bauteils;
- Fig. 2: eine schematische Gesamtdarstellung einer zweiten Ausführungsform des mikromechanischen Bauteils;
- Fig. 3a und 3b: Gesamt- und Teildarstellungen einer dritten Ausführungsform des mikromechanischen Bauteils;
- Fig. 4: eine schematische Teildarstellung einer vierten Ausführungsform des mikromechanischen Bauteils;
- Fig. 5a bis 5d: Gesamt- und Teildarstellungen einer fünften Ausführungsform des mikromechanischen Bauteils, die nicht unter den Anspruchsgegenstand fällt; und
- Fig. 6: ein Flussdiagramm zum Erläutern einer Ausführungsform des Herstellungsverfahrens.

### Ausführungsformen der Erfindung

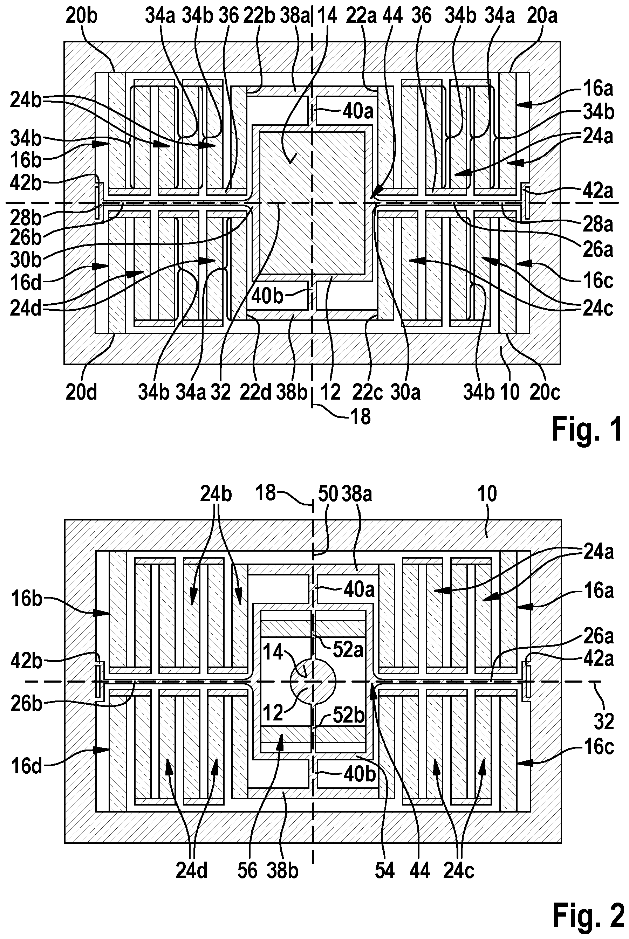

Fig. 1 zeigt eine schematische Gesamtdarstellung einer ersten Ausführungsform des mikromechanischen Bauteils.

Das in Fig. 1 schematisch dargestellte mikromechanische Bauteil umfasst eine Halterung 10 und ein in Bezug zu der Halterung 10 verstellbares Teil 12. Beispielhaft ist das verstellbare Teil 12 als Mikrospiegel 12 mit einer reflektierenden Oberfläche 14 ausgebildet. Eine Ausbildbarkeit des mikromechanischen Bauteils ist jedoch nicht auf dessen Ausstattung mit dem Mikrospiegel 12 als dem verstellbaren Teil 12 limitiert. Erfindungsgemäß ist die Halterung 10 in Rahmenform.

Das mikromechanische Bauteil der Fig. 1 hat eine erste mäanderförmige Feder 16a und eine bezüglich einer ersten Symmetrieebene 18 spiegelsymmetrisch zu der ersten mäanderförmigen Feder 16a ausgebildete zweite mäanderförmige Feder 16b. Als optionale Weiterbildung umfasst das mikromechanische Bauteil noch eine dritte mäanderförmige Feder 16c und eine bezüglich der ersten Symmetrieebene 18 spiegelsymmetrisch zu der dritten mäanderförmigen Feder 16c ausgebildete vierte mäanderförmige Feder 16d. Jede der mäanderförmigen Federn 16a bis 16d ist an je einem äußeren Ende 20a bis 20c der jeweiligen mäanderförmigen Feder 16a bis 16d direkt oder indirekt an der Halterung 10 angebunden. Außerdem ist jede der mäanderförmigen Federn 16a bis 16d an je einem inneren Ende 22a bis 22d der jeweiligen mäanderförmigen Feder 16a bis 16d direkt oder indirekt an dem verstellbaren Teil 12 angebunden. Aufgrund ihrer mäanderförmigen Form können die mäanderförmigen Federn 16a bis 16d vergleichsweise lang ausgebildet sein, ohne dass die Einzellängen der mäanderförmigen Federn 16a bis 16d zu einer signifikanten Vergrößerung des mikromechanischen Bauteils beitragen. Eine Einzellänge der mäanderförmigen Federn 16a bis 16d kann beispielsweise größer-gleich 8 mm (Millimeter), insbesondere größer-gleich 10 mm (Millimeter), speziell größer-gleich 12 mm (Millimeter), sein.

Des Weiteren sind zumindest an und/oder in der ersten mäanderförmigen Feder 16a eine erste Aktoreinrichtung 24a und an und/oder in der zweiten mäanderförmigen Feder 16b eine zweite Aktoreinrichtung 24b derart ausgebildet, dass mittels der ersten Aktoreinrichtung 24a und der zweiten Aktoreinrichtung 24b periodische und bezüglich der ersten Symmetrieebene 18 spiegelsymmetrische Verformungen der ersten mäanderförmigen Feder 16a und der zweiten mäanderförmigen Feder 16b anregbar sind/angeregt werden. Zumindest mittels der bezüglich der ersten Symmetrieebene 18 spiegelsymmetrischen Verformungen der ersten mäanderförmigen Feder 16a und der zweiten mäanderförmigen Feder 16b kann das verstellbare Teil 12 damit in Bezug zu der Halterung 10 verstellt werden. Als optionale Weiterbildung weist das mikromechanische Bauteil der Fig. 1 noch an und/oder in der dritten mäanderförmigen Feder 16c eine dritte Aktoreinrichtung 24c und an und/oder in der vierten mäanderförmigen Feder 16d eine vierte Aktoreinrichtung 24d derart auf, dass mittels der dritten Aktoreinrichtung 24c und der vierten Aktoreinrichtung 24d periodische und bezüglich der ersten Symmetrieebene 18 spiegelsymmetrische Verformungen der dritten mäanderförmigen Feder 16c und der vierten mäanderförmigen Feder 16d anregbar sind/angeregt werden. Dabei ist es wünschenswert, dass die periodischen und bezüglich der ersten Symmetrieebene 18 spiegelsymmetrischen Verformungen der dritten mäanderförmigen Feder 16c und der vierten mäanderförmigen Feder 16d gegenphasig zu den periodischen und spiegelsymmetrischen Verformungen der ersten mäanderförmigen Feder 16a und der zweiten mäanderförmigen Feder 16b sind. Wie unten genauer erläutert wird, können in diesem Fall die Verformungen aller vier mäanderförmigen Federn 16a bis 16d zur Übertragung vergleichsweise großer Verstellkräfte auf das verstellbare Element 12 genutzt werden.

Das in Fig. 1 schematisch wiedergegebene mikromechanische Bauteil weist auch eine erste Torsionsfeder 26a und eine zweite Torsionsfeder 26b, welche an je einem äußeren Ende 28a oder 28b der jeweiligen Torsionsfeder 26a oder 26b direkt an der Halterung 10 und an je einem inneren Ende 30a oder 30b der jeweiligen Torsionsfeder 26a und 26b direkt an dem verstellbaren Teil 12 angebunden sind. Die erste Torsionsfeder 26a und die zweite Torsionsfeder 26b erstrecken sich jeweils entlang einer Drehachse 32.

Deshalb ist das verstellbare Teil 12 mittels zumindest der periodischen und spiegelsymmetrischen Verformungen der ersten mäanderförmigen Feder 16a und der zweiten mäanderförmigen Feder 16b (und eventuell der dazu gegenphasigen Verformungen der dritten mäanderförmigen Feder 16c und der vierten mäanderförmigen Feder 16d) in Bezug zu der Halterung 10 um die Drehachse 32 verstellbar.

Die erste Torsionsfeder 26a und die zweite Torsionsfeder 26b bewirken eine "Sicherung" der gewollten Drehachse 32 gegenüber unerwünschten Verstellbewegungen des verstellbaren Teils 12. Die erste Torsionsfeder 26a und die zweite Torsionsfeder 26b tragen somit zur Stabilisierung der gewünschten Drehbewegung des verstellbaren Teils 12 um die Drehachse 32 bei. Insbesondere erhöhen die erste Torsionsfeder 26a und die zweite Torsionsfeder 26b eine Steifigkeit des mikromechanischen Bauteils gegenüber einer unerwünschten Verstellbewegung des verstellbaren Teils 12 in eine senkrecht zur Ebene der Torsionsfedern 26a und 26b ausgerichtete Richtung. Ein Auftreten/eine Häufigkeit von weiteren unerwünschten Verstellbewegungen des verstellbaren Teils, d. h. ein Auftreten/eine Häufigkeit der Anregung von sogenannten Störmoden, ist deshalb mittels der ersten Torsionsfeder 26a und der zweiten Torsionsfeder 26b reduziert/verhindert. Dies gewährleistet einen verlässlicheren Betrieb des mikromechanischen Bauteils.

Sofern die dritte mäanderförmige Feder 16c und die vierte mäanderförmige Feder 16d an dem mikromechanischen Bauteil ausgebildet sind, sind die dritte mäanderförmige Feder 16c und die vierte mäanderförmige Feder 16d vorzugsweise bezüglich einer senkrecht zu der ersten Symmetrieebene 18 ausgerichteten zweiten Symmetrieebene spiegelsymmetrisch zu der ersten mäanderförmigen Feder 16a und der zweiten mäanderförmigen Feder 16b, wobei die Drehachse 32 innerhalb der (nicht skizzierten) zweiten Symmetrieebene liegt. Auch die Einhaltung einer derartigen Symmetrie an dem mikromechanischen Bauteil trägt vorteilhaft zur Reduzierung von Störmoden bei.

In dem Beispiel der Fig. 1 umfassen die Aktoreinrichtungen 24a bis 24d jeweils mehrere piezoelektrische Aktorschichten 24a bis 24d aus mindestens einem piezoelektrischen Material. Jede mäanderförmige Feder 16a bis 16d kann piezoelektrische Aktorschichten 24a bis 24d aus dem gleichen piezoelektrischen Material oder aus verschiedenen piezoelektrischen Materialien aufweisen. Das mindestens eine piezoelektrische Material kann beispielsweise ein PZT-Bimetall (Blei-Zirkonium-Titanat) sein. Die piezoelektrischen Aktorschichten 24a bis 24d können z.B. eine Schichtdicke zwischen 1 µm (Mikrometer) bis 2 µm (Mikrometer) haben.

Die jeweiligen piezoelektrischen Aktorschichten 24a bis 24d sind an und/oder in mehreren Teilabschnitten 34a und 34b der zugeordneten mäanderförmigen Feder 16a bis 16d ausgebildet. Vorzugsweise sind jeweils zwei benachbarte mit piezoelektrischen Aktorschichten 24a bis 24d ausgebildete Teilabschnitte 34a und 34b der jeweiligen mäanderförmigen Feder 16a bis 16d über je einen Zwischenabschnitt 36 der jeweiligen mäanderförmigen Feder 16a bis 16d miteinander verbunden, wobei unter den Zwischenabschnitten 36 "Federabschnitte frei von dem mindestens einen piezoelektrischen Material" zu verstehen sind. Ebenso ist es vorteilhaft, wenn sich die mit piezoelektrischen Aktorschichten 24a bis 24d ausgebildeten Teilabschnitte 34a und 34b der mäanderförmigen Federn 16a bis 16d parallel zueinander und senkrecht zu der Drehachse 32 erstrecken.

Zum Zusammenwirken mit den piezoelektrischen Aktorschichten 24a bis 24d weisen die Aktoreinrichtungen 24a bis 24d auch jeweils mindestens eine (nicht dargestellte) elektrische Leitung, welche an und/oder in der zugeordneten mäanderförmigen Feder 16a bis 16d ausgebildet ist, auf. Damit kann mindestens ein Spannungssignal an die piezoelektrischen Aktorschichten 24a bis 24d derart angelegt werden, dass zumindest die periodischen und spiegelsymmetrischen Verformungen der ersten mäanderförmigen Feder 16a und der zweiten mäanderförmigen Feder 16b (und vorzugsweise auch die dazu gegenphasigen Verformungen der dritten mäanderförmigen Feder 16c und der vierten mäanderförmigen Feder 16d) bewirkbar sind/bewirkt werden. Eine derartige Ausbildung der Aktoreinrichtungen 24a bis 24d als piezoelektrische Aktoreinrichtungen 24a bis 24d zeichnet sich durch hohe Verstellkräfte, jedoch nur geringe Stellwege, aus. Vorzugsweise erfolgt ein Verstellen des verstellbaren Teils 12 um die Drehachse 32 mittels der hier beschriebenen piezoelektrischen Aktoreinrichtungen 24a bis 24d nicht resonant.

Wird keine Spannung an die piezoelektrischen Aktorschichten 24a bis 24d angelegt, so liegt das verstellbare Teil 12 in seiner sogenannten Ruhestellung in Bezug zu der Halterung 10 vor. Durch das Anlegen des mindestens einen Spannungssignals an die piezoelektrischen Aktorschichten 24a bis 24d können wahlweise eine Zugspannung oder eine Biegespannung auf den jeweiligen Teilabschnitt 34a und 34b ausgeübt werden. Vorzugsweise sind für jede der mäanderförmigen Federn 16a bis 16d jeweils mehrere erste Teilabschnitte 34a und mehrere zweite Teilabschnitte 34 definierbar, wobei jeweils zwischen zwei ersten Teilabschnitten 34a der gleichen mäanderförmigen Feder 16a bis 16d ein zweiter Teilabschnitt 34b der jeweiligen mäanderförmigen Feder 16a bis 16d und zwischen zwei zweiten Teilabschnitten 34b der gleichen mäanderförmigen Feder 16a bis 16d ein erster Teilabschnitt 34a der jeweiligen mäanderförmigen Feder 16a bis 16d liegen. Das Anlegen des mindestens einen Spannungssignals an die piezoelektrischen Aktorschichten 24a bis 24d erfolgt in diesem Fall so, dass abwechseln entweder eine Zugspannung auf alle ersten Teilabschnitte 34a der mäanderförmigen Federn 16a bis 16d und eine Biegespannung auf alle zweiten Teilabschnitte 34b der mäanderförmigen Federn 16a bis 16d oder eine Biegespannung auf alle ersten Teilabschnitte 34a der mäanderförmigen Federn 16a bis 16d und eine Zugspannung auf alle zweiten Teilabschnitte 34b der mäanderförmigen Federn 16a bis 16d ausgeübt wird. Bei einem konkaven Verbiegen aller ersten Teilabschnitten 34a der mäanderförmigen Federn 16a bis 16d werden die zweiten Teilabschnitte 34b der mäanderförmigen Federn 16a bis 16d gleichzeitig konvex verbogen, während bei einem konvexen Verbiegen aller ersten Teilabschnitten 34a der mäanderförmigen Federn 16a bis 16d die zweiten Teilabschnitte 34b der mäanderförmigen Federn 16a bis 16d gleichzeitig konkav verbogen werden. Ein derartiges "abwechselndes konvexes und konkaves Verbiegen" der mäanderförmigen Federn 16a bis 16d bewirkt ein vergleichsweise starkes Verstellen des verstellbaren Teils 12 aus seiner Ruhestellung um einen relativ großen Verstellwinkel um die Drehachse 32 in Bezug zu der Halterung 10. Der mittels des "abwechselnden konvexen und konkaven Verbiegens" der mäanderförmigen Federn 16a bis 16d bewirkte Verstellwinkel des verstellbaren Teils 12 um die Drehachse 32 kann beispielsweise größer-gleich 4° (Grad) sein. In dem Beispiel der Fig. 1 sind die inneren Enden 22a und 22b der ersten mäanderförmigen Feder 16a und der zweiten mäanderförmigen Feder 16d an einem auf einer ersten Seite der Drehachse 32 liegenden und parallel zu der Drehachse 32 verlaufenden ersten Befestigungssteg 38a angebunden. Entsprechend sind auch die inneren Enden 22c und 22d der dritten mäanderförmigen Feder 16c und der vierten mäanderförmigen Feder 16d an einem parallel zu der Drehachse 32 verlaufenden zweiten Befestigungssteg 38b, welcher auf einer zweiten Seite der Drehachse 32 liegt, angebunden. Das verstellbare Teil 12 ist über je ein sich senkrecht zu der Drehachse 32 erstreckendes Verbindungselement 40a und 40b an den Befestigungsstegen 38a und 38b angebunden. Die periodischen und spiegelsymmetrischen Verformungen der ersten mäanderförmigen Feder 16a und der zweiten mäanderförmigen Feder 16b (und eventuell die dazu gegenphasigen Verformungen der dritten mäanderförmigen Feder 16c und der vierten mäanderförmigen Feder 16d) bewirken gegenphasige Bewegungen der Befestigungsstege 38a und 38b senkrecht zu der Drehachse 32, und damit ein "Wippen" des verstellbaren Teils 12 um die Drehachse 32.

Wie in Fig. 1 erkennbar ist, können die erste Torsionsfeder 26a und die zweite Torsionsfeder 26b noch mit einem weiteren Federtyp "integriert" sein. Beispielsweise sind die äußeren Enden 28a und 28b der Torsionsfedern 26a und 26b jeweils noch an einer U-Feder 42a und 42b angebunden, wobei die jeweilige U-Feder 42a und 42b sich zu der Halterung 10 hin "aufgabelt". Eine derartige "Integration" der Torsionsfedern 26a und 26b mit einem weiteren Federtyp kann eine Verstellbarkeit des verstellbaren Teils 12 um die Drehachse 32 in Bezug zu der Halterung 10 verbessern, wobei trotzdem die Torsionsfedern 26a und 26b unerwünschten Störmoden vorteilhaft entgegenwirken.

Erfindungsgemäß umfasst das mikromechanische Bauteil noch zumindest eine Sensoreinrichtung 44, welche dazu ausgelegt ist, mindestens ein zu einer Auslenkung des verstellbaren Teils 12 aus seiner Ruhestellung in Bezug zu der Halterung 10 korrespondierendes Sensorsignal auszugeben oder bereitzustellen. Die Sensoreinrichtung 44 kann beispielsweise eine piezoelektrische oder piezoresistive Sensoreinrichtung 44 sein. Vorzugsweise ist die Sensoreinrichtung 44 auf und/oder in einem

"Verankerungsbereich" der ersten Torsionsfeder 26a an dem verstellbaren Teil 12 und/oder auf und/oder in einem "Verankerungsbereich" der zweiten Torsionsfeder 26b an dem verstellbaren Teil 12 ausgebildet. Die Ausbildung der Sensoreinrichtung 44 auf und/oder in dem "Verankerungsbereich" der ersten Torsionsfeder 26a an dem verstellbaren Teil 12 und/oder auf und/oder in dem "Verankerungsbereich" der zweiten Torsionsfeder 26b an dem verstellbaren Teil 12 ermöglicht eine eindeutige Detektion/Erkennung einer Auslenkung des verstellbaren Teils 12 aus seiner Ruhestellung um die Drehachse 32 in Bezug zu der Halterung 10. Insbesondere ist eine derartige Ausbildung der Sensoreinrichtung 44 vorteilhafter als die herkömmliche Positionierung einer Sensorik an einer der mäanderförmigen Federn 16a bis 16d, welche oft keine sichere Korrelation zur Auslenkung des verstellbaren Teils 12 erlaubt und des Weiteren zu dem Nachteil führt, dass Störmoden des mikromechanischen Bauteils fälschlicherweise als die gewünschte Auslenkung des verstellbaren Teils 12 aus seiner Ruhestellung um die Drehachse 32 gedeutet werden.

Erfindungsgemäß ist die Sensoreinrichtung 44 außerdem über mindestens eine an und/oder in der ersten und/oder zweiten Torsionsfeder 26a oder 26b ausgebildete (nicht skizzierte) Signalleitung mit einer auf der Halterung 10 ausgebildeten Auswerteelektronik oder einem auf der Halterung 10 ausgebildeten Auswerteelektronik-Anbindungskontakt verbunden. Die Torsionsfedern 26a und 26b bieten "zusätzliche Anbindungen" des verstellbaren Teils 12 an die Halterung 10, welche zur Anbindung der mindestens einen Signalleitung der Sensoreinrichtung 44 genutzt werden. Auf eine Ausbildung der mindestens einen Signalleitung an und/oder in den mindestens zwei mäanderförmigen Federn 16a bis 16d kann somit problemlos verzichtet werden. Eine Biegesteifigkeit der mindestens zwei mäanderförmigen Federn 16a bis 16d wird somit nicht durch die mindestens eine über mindestens eine der Torsionsfedern 26a und 26b geführte Signalleitung beeinträchtigt. Des Weiteren wird die Signalleitung weder durch die konvex/konkave Verbiegung der mäanderförmigen Federn 16a bis 16d beeinflusst, noch stören sich die elektrischen Signale der Aktor- und Sensorsignalleitung.

Fig. 2 zeigt eine schematische Gesamtdarstellung einer zweiten Ausführungsform des mikromechanischen Bauteils.

Das in Fig. 2 schematisch dargestellte mikromechanische Bauteil ist eine Weiterbildung der zuvor beschriebenen Ausführungsform. Insbesondere ist das verstellbare Teil 12 des mikromechanischen Bauteils der Fig. 2 noch um eine geneigt/senkrecht zu der Drehachse 32 ausgerichtete weitere Drehachse 50 verstellbar. Vorzugsweise liegt die weitere Drehachse 50 in der ersten Symmetrieebene 18 (in Fig. 2 nicht eingezeichnet).

Das verstellbare Teil 12 ist über zwei sich entlang der weiteren Drehachsen 50 erstreckenden Zwischenfedern 52a und 52b in einem Innenrahmen 54 aufgehängt, wobei der Innenrahmen 54 zwischen den Verbindungsteilen 40a und 40b befestigt ist. Zum Verstellen des verstellbaren Teils um die weitere Drehachse 50 kann mindestens eine weitere Aktoreinrichtung 56 an dem verstellbaren Teil 12 und/oder an dem Innenrahmen 54 ausgebildet sein. Die mindestens eine weitere Aktoreinrichtung 56 ist in Fig. 2 jedoch nur schematisch wiedergegeben. Es wird jedoch darauf hingewiesen, dass die mindestens eine weitere Aktoreinrichtung 56 zum Verstellen des verstellbaren Teils 12 um die weitere Drehachse 50 "getrennt" von den vier Aktoreinrichtungen 24a bis 24d zum Verstellen des verstellbaren Teils 12 um die Drehachse 32 ausgebildet ist. Durch die "getrennte" Ausbildung der vier Aktoreinrichtungen 24a bis 24d von der mindestens einen weiteren Aktoreinrichtung 56 können die vier Aktoreinrichtungen 24a bis 24d unabhängig von der mindestens einen weiteren Aktoreinrichtung 56 so betrieben werden, dass sich die unterschiedlichen Verstellbewegungen/rotatorischen Moden des verstellbaren Teils 12 geringer beeinflussen. Während das Verstellen des verstellbaren Teils 12 um die Drehachse 32 mittels der vier Aktoreinrichtungen 24a bis 24d vorzugsweise nicht resonant erfolgt, kann zum Verstellen des verstellbaren Teils 12 um die weitere Drehachse 50 eine resonante Schwingung des verstellbaren Teils 12 um die weitere Drehachse 50 mittels der mindestens einen weiteren Aktoreinrichtung 56 anregbar sein.

Bezüglich weiterer Merkmale des mikromechanischen Bauteils der Fig. 2 wird auf die zuvor beschriebene Ausführungsform verwiesen.

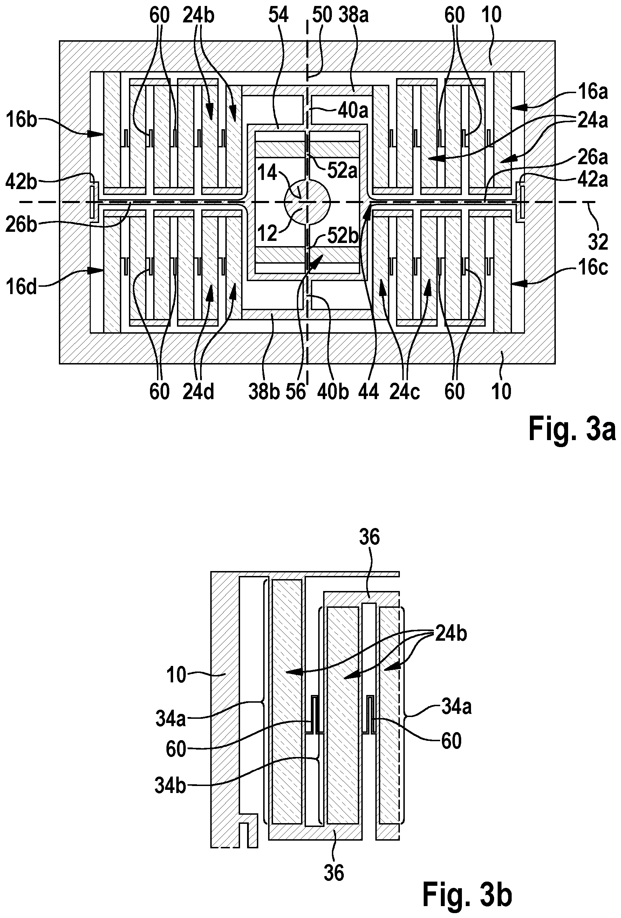

Fig. 3a und 3b zeigen Gesamt- und Teildarstellungen einer dritten Ausführungsform des mikromechanischen Bauteils.

Das in Fig. 3a und 3b schematisch dargestellte mikromechanische Bauteil ist eine Weiterbildung der zuvor beschriebenen Ausführungsform. Als Ergänzung zu den oben erläuterten Merkmalen sind jeweils zwei benachbarte mit piezoelektrischen Aktorschichten 24a bis 24d ausgebildete Teilabschnitte 34a und 34b der mäanderförmigen Federn 16a bis 16d, z.B. je ein erster Teilabschnitt 34a und je ein zweiter Teilabschnitt 34b der gleichen mäanderförmigen Feder 16a bis 16d, über je ein Zwischenfederelement 60 miteinander verbunden. Die Zwischenfederelemente 60 können beispielsweise U-Federn 60 sein. Vorzugsweise sind die Zwischenfederelemente 60 in einer Mitte der zwei benachbarten mit piezoelektrischen Aktorschichten 24a bis 24d ausgebildeten und sich senkrecht zu der Drehachse 32 erstreckenden Teilabschnitte 34a und 34b der gleichen mäanderförmigen Feder 16a bis 16d ausgebildet, da in diesem Fall bei einem Ausüben einer Zugspannung auf einen der beiden Teilabschnitte 34a oder 34b und gleichzeitigem Ausüben einer Biegespannung auf den anderen der beiden Teilabschnitte 34a oder 34b die Verankerungsbereiche des jeweiligen Zwischenfederelements 60 kaum ausgelenkt werden.

Bezüglich weiterer Merkmale des mikromechanischen Bauteils der Fig. 2 wird auf die zuvor beschriebenen Ausführungsformen verwiesen.

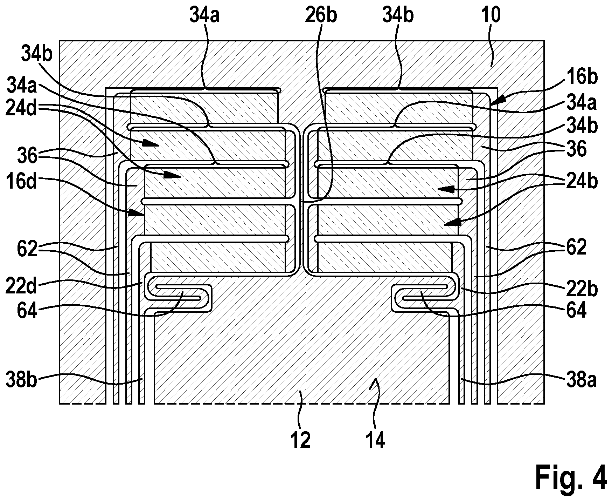

Fig. 4 zeigt eine schematische Teildarstellung einer vierten Ausführungsform des mikromechanischen Bauteils.

Bei dem mikromechanischen Bauteil der Fig. 4 ist mindestens einer der Zwischenabschnitte 36 der ersten mäanderförmigen Feder 16a (und entsprechend mindestens einer der Zwischenabschnitte 36 der dritten mäanderförmigen Feder 16c) über je ein Stegelement 62 mit dem dazu bezüglich der ersten Symmetrieebene 18 spiegelsymmetrischen Zwischenabschnitt 36 der zweiten mäanderförmigen Feder 16b (bzw. dem dazu bezüglich der ersten Symmetrieebene 18 spiegelsymmetrischen Zwischenabschnitt 36 der vierten mäanderförmigen Feder 16d) verbunden. Die Stegelemente 62 erstrecken sich bevorzugter Weise parallel zu der Drehachse 32. Die Stegelemente 62 tragen zur gewünschten Einhaltung der Symmetrien der Verformungen der Federn 16a bis 16d bei, und reduzieren damit zusätzlich eine Häufigkeit/Intensität der Anregung von Störmoden. Insbesondere kann jeder der bezüglich der Teilabschnitte 34a und 34b der ersten mäanderförmigen Feder 16a auf der von der Drehachse 32 weg gerichteten Seite liegenden Zwischenabschnitte 36 der ersten mäanderförmigen Feder 16a (und entsprechend jeder der bezüglich der Teilabschnitte 34a und 34b der dritten mäanderförmigen Feder 16c auf der von der Drehachse 32 weg gerichteten Seite liegenden Zwischenabschnitte 36 der dritten mäanderförmigen Feder 16c) über je ein Stegelement 62 mit dem dazu bezüglich der ersten Symmetrieebene 18 spiegelsymmetrischen Zwischenabschnitt 36 der zweiten mäanderförmigen Feder 16b (bzw. dem dazu bezüglich der ersten Symmetrieebene 18 spiegelsymmetrischen Zwischenabschnitt 36 der vierten mäanderförmigen Feder 16d) verbunden sein.

Wie in Fig. 4 dargestellt, können die inneren Enden 22a bis 22d der mäanderförmigen Federn 16a und 16b zusätzlich zu dem zugeordneten Befestigungssteg 38a oder 38b noch über je eine federnde Aufhängung 64 an dem verstellbaren Teil 12, bzw. an dem Innenrahmen 54, angebunden sein. Die federnden Aufhängungen 64 realisieren "Entspannungseinheiten", über welche während der Verformungen der mäanderförmigen Federn 16a bis 16d auftretende Zugspannungen ausgeglichen werden können. Die jeweilige federnde Aufhängung 64 kann beispielsweise in Form einer mäanderförmigen Feder 64, welche an einem ersten Ende an dem inneren Ende 22a bis 22d der zugeordneten mäanderförmigen Feder 16a und 16b und an einem zweiten Ende an dem verstellbaren Teil 12, bzw. an dem Innenrahmen 54, angebunden ist, ausgebildet sein.

Bezüglich weiterer Merkmale des mikromechanischen Bauteils der Fig. 4 wird auf die zuvor beschriebene Ausführungsform der Fig. 1 verwiesen.

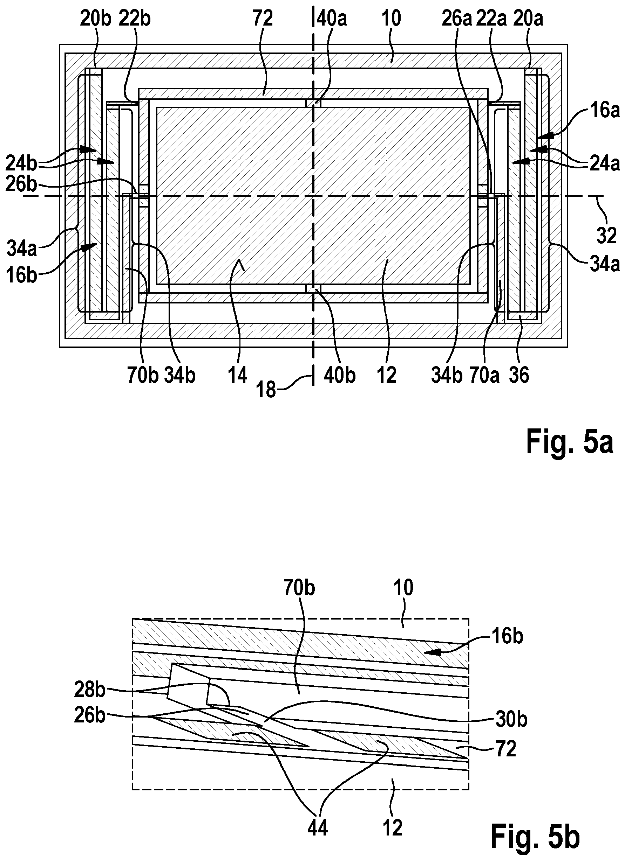

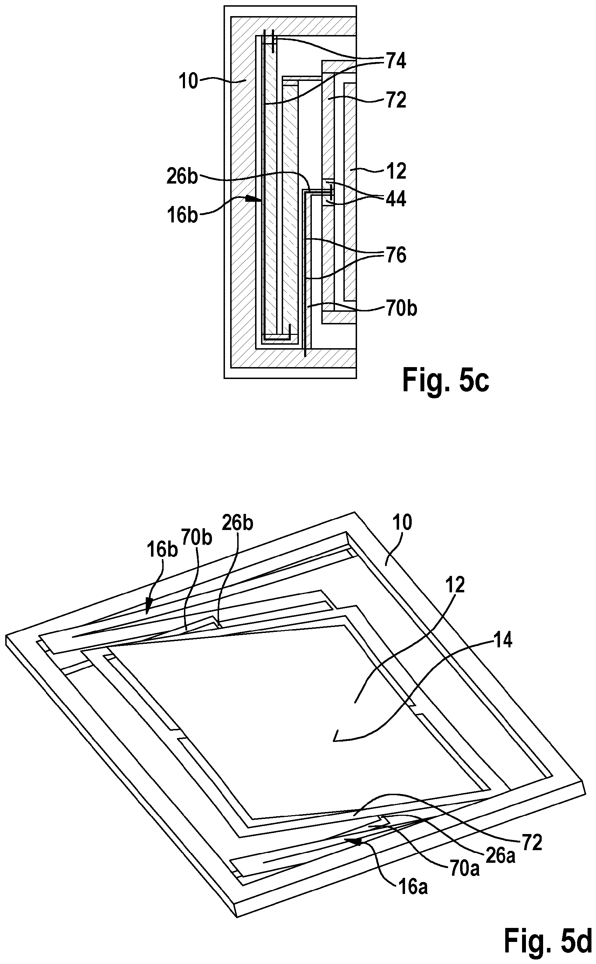

Fig. 5a bis 5d zeigen Gesamt- und Teildarstellungen einer fünften Ausführungsform des mikromechanischen Bauteils, die nicht unter den Anspruchsgegenstand fällt.

Das in Fig. 5a bis 5d schematisch dargestellte mikromechanische Bauteil weist nur die erste mäanderförmige Feder 16a und die bezüglich der ersten Symmetrieebene 18 spiegelsymmetrisch zu der ersten mäanderförmigen Feder 16a ausgebildete zweite mäanderförmige Feder 16b auf. Auf weitere mäanderförmige Federn ist bei dem mikromechanischen Bauteil der Fig. 5a bis 5d verzichtet. Aufgrund der zusätzlichen (direkten oder indirekten) Anbindung des verstellbaren Teils 12 über die erste Torsionsfeder 26a und die zweite Torsionsfeder 26b, welche sich jeweils entlang der Drehachse 32 erstrecken, ist jedoch selbst bei einem Verzicht auf weitere mäanderförmige Federn die gewünschte Verstellbewegung des verstellbaren Teils 12 um die Drehachse 32 verlässlich ausführbar, wobei einem Häufigkeit von Störmoden gegenüber dem Stand der Technik deutlich reduziert ist.

Vorteilhafterweise sind das äußere Ende 28a der ersten Torsionsfeder 26a an einem ersten Befestigungssteg 70a und das äußere Ende 28b der zweiten Torsionsfeder 26b an einem zweiten Befestigungssteg 70b befestigt, wobei die Befestigungsstege 70a und 70b senkrecht zu der Drehachse 32 verlaufen und der erste Befestigungssteg 70a zwischen der ersten mäanderförmigen Feder 16a und dem verstellbaren Teil 12, bzw. einem das verstellbare Teil 12 umgebenden Innenrahmen 72, und der zweite Befestigungssteg 70b zwischen der zweiten mäanderförmigen Feder 16b und dem verstellbaren Teil 12, bzw. dem Innenrahmen 72, angeordnet sind. Wie in Fig. 5a erkennbar, ermöglicht eine Anbindung der Torsionsfedern 26a und 26b an derartige Befestigungsstege 70a und 70b eine relativ große Ausdehnung der mäanderförmigen Federn 16a und 16b senkrecht zu der Drehachse 32.

Wie in Fig. 5b erkennbar, können die Befestigungsstege 70a und 70b eine größere Höhe und eine größere Breite als die Torsionsfedern 26a und 26b aufweisen. Ein unerwünschtes "Herausheben" des verstellbaren Teils 12 aus einer Ebene der zwei Torsionsfedern 26a und 26b, bzw. eine Störmode des verstellbaren Teils 12 senkrecht zu der Drehachse 32, können mittels einer derartigen Ausbildung der Befestigungsstege 70a und 70b verlässlich unterdrückt werden.

Auch bei dem mikromechanischen Bauteil der Fig. 5a bis 5d ist die Drehachse 32 nicht (ausschließlich) über die Ausbildung der mäanderförmigen Federn 16a und 16b, sondern über die Ausbildung der Torsionsfedern 26a und 26b festlegbar.

Durch Variieren der Lage der Torsionsfedern 26a und 26b kann die Lage der Drehachse 32 variiert werden. Außerdem können mittels der Ausbildung der Torsionsfedern 26a und 26b Eigenfrequenzen der gewünschten Verstellbewegung des verstellbaren Teils 12 um die Drehachse 32 festgelegt werden. Durch Variieren der Angriffspunkte der inneren Enden 22a und 22b der mäanderförmigen Federn 16a und 16b können auf das verstellbare Teil 12, bzw. den umgebenden Innenrahmen 72, bewirkte Drehmomente variiert werden. Fig. 5c zeigt die mindestens eine elektrische Leitung 74 zum Anlegen des mindestens einen Spannungssignals an die piezoelektrischen Aktorschichten 24a und 24b der ersten mäanderförmigen Feder 16a und der zweiten mäanderförmigen Feder 16b und die mindestens eine an und/oder in der ersten Torsionsfeder 26a und/oder der zweiten Torsionsfeder 26b ausgebildete Signalleitung 76 zur Anbindung der mindestens einen Sensoreinrichtung 44, welche auf und/oder in dem verstellbaren Teil 12, bzw. dem umgebenden Innenrahmen 72, ausgebildet ist. Damit weist auch das mikromechanische Bauteil der Fig. 5a bis 5d eine Trennung von Aktuations- und Detektionselementen auf, wodurch ein Übersprechen zwischen durch die Leitungen 74 und 76 geführten Signalen verhindert ist.

Bezüglich weiterer Merkmale des mikromechanischen Bauteils der Fig. 5a bis 5d wird auf die zuvor beschriebenen Ausführungsformen verwiesen.

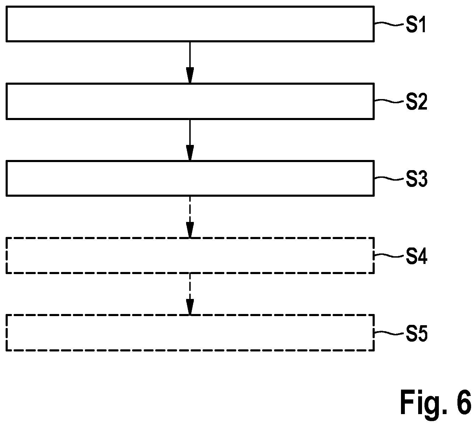

Fig. 6 zeigt ein Flussdiagramm zum Erläutern einer Ausführungsform des Herstellungsverfahrens.

Alle oben beschriebenen mikromechanischen Bauteile der ersten bis vierten Ausführungsform können mittels des im Weiteren beschriebenen Herstellungsverfahrens hergestellt werden. Eine Ausführbarkeit des Herstellungsverfahrens ist jedoch nicht auf das Herstellen der oben beschriebenen mikromechanischen Bauteile der ersten bis vierten Ausführungsform beschränkt.

In einem Verfahrensschritt S1 wird ein verstellbares Teil an eine Halterung über zumindest eine erste mäanderförmige Feder und eine bezüglich einer ersten Symmetrieebene spiegelsymmetrisch zu der ersten mäanderförmigen Feder ausgebildete zweite mäanderförmige Feder angebunden, wobei je ein äußeres Ende der jeweiligen mäanderförmigen Feder direkt oder indirekt an der Halterung und je ein inneres Ende der jeweiligen mäanderförmigen Feder direkt oder indirekt an dem verstellbaren Teil angebunden werden. Außerdem werden in einem Verfahrensschritt S2 zumindest eine erste Aktoreinrichtung an und/oder in der ersten mäanderförmigen Feder und einerzweiten Aktoreinrichtung an und/oder in der zweiten mäanderförmigen Feder derart ausgebildet, dass bei einem Betrieb des späteren mikromechanischen Bauteils mittels der ersten Aktoreinrichtung und der zweiten Aktoreinrichtung periodische und bezüglich der ersten Symmetrieebene spiegelsymmetrische Verformungen der ersten mäanderförmigen Feder und der zweiten mäanderförmigen Feder angeregt werden, wodurch das verstellbare Teil in Bezug zu der Halterung verstellt wird.

Das Herstellungsverfahren umfasst auch einen Verfahrensschritt S3, in welchem eine erste Torsionsfeder und eine zweite Torsionsfeder ausgebildet werden, welche sich jeweils entlang einer Drehachse erstrecken, wobei je ein äußeres Ende der jeweiligen Torsionsfeder direkt an der Halterung und je ein inneres Ende der jeweiligen Torsionsfeder direkt an dem verstellbaren Teil so angebunden werden. Dies bewirkt, dass das verstellbare Teil mittels zumindest der periodischen und spiegelsymmetrischen Verformungen der ersten mäanderförmigen Feder und der zweiten mäanderförmigen Feder in Bezug zu der Halterung um die Drehachse verstellt wird. Damit bewirkt auch das hier beschriebene Herstellungsverfahren die oben erläuterten Vorteile. Zum Ausführen der Verfahrensschritte S1 und S3 können die jeweiligen Komponenten beispielsweise aus monokristallinen, polykristallinen oder epi-polykristallinen Silizium, speziell aus einer Siliziumschicht eines SOI-Substrats (Silicon-On-Isolator-Substrat) herausstrukturiert werden.

Erfindungsgemäß umfasst das Herstellungsverfahren noch die Verfahrensschritte S4 und S5. In dem Verfahrensschritt S4 wird eine Sensoreinrichtung zum Bereitstellen oder Ausgeben mindestens eines zu einer Auslenkung des verstellbaren Teils aus seiner Ruhestellung in Bezug zu der Halterung korrespondierenden Sensorsignals ausgebildet. In dem Verfahrensschritt S5 wird die Sensoreinrichtung über mindestens eine an und/oder in der ersten Torsionsfeder und/oder der zweiten Torsionsfeder ausgebildete Signalleitung mit einer auf der Halterung ausgebildeten Auswerteelektronik oder einem auf der Halterung ausgebildeten Auswerteelektronik-Anbindungskontakt verbunden. Auch weitere Komponenten der oben beschriebenen mikromechanischen Bauteile können mittels entsprechender Verfahrensschritte ausgebildet werden. Die oben beschriebenen mikromechanischen Bauteile sind technologisch auf einfache Weise realisierbar.

## Patentansprüche

1. Mikromechanisches Bauteil mit:
einer Halterung (10) in Rahmenform;
einem verstellbaren Teil (12); und
einer ersten mäanderförmigen Feder (16a) und einer bezüglich einer ersten Symmetrieebene (18) spiegelsymmetrisch zu der ersten mäanderförmigen Feder (16a) ausgebildeten zweiten mäanderförmigen Feder (16b), welche an je einem äußeren Ende (20a, 20b) der jeweiligen mäanderförmigen Feder (16a, 16b) direkt oder indirekt an der Halterung (10) und an je einem inneren Ende (22a, 22b) der jeweiligen mäanderförmigen Feder (16a, 16b) direkt oder indirekt an dem verstellbaren Teil (12) angebunden sind;
wobei an und/oder in der ersten mäanderförmigen Feder (16a) eine erste Aktoreinrichtung (24a) und an und/oder in der zweiten mäanderförmigen Feder (16b) eine zweite Aktoreinrichtung (24b) derart ausgebildet sind, dass mittels der ersten Aktoreinrichtung (24a) und der zweiten Aktoreinrichtung (24b) periodische und bezüglich der ersten Symmetrieebene (18) spiegelsymmetrische Verformungen der ersten mäanderförmigen Feder (16a) und der zweiten mäanderförmigen Feder (16b) anregbar sind, wodurch das verstellbare Teil (12) in Bezug zu der Halterung (10) verstellbar ist;
einer ersten Torsionsfeder (26a) und einer zweiten Torsionsfeder (26b), welche sich jeweils entlang einer Drehachse (32) erstrecken und an je einem äußeren Ende (28a, 28b) der jeweiligen Torsionsfeder (26a, 26b) an der Halterung (10)
und an je einem inneren Ende (30a, 30b) der jeweiligen Torsionsfeder (26a, 26b) direkt an dem verstellbaren Teil (12) angebunden sind,
wobei das verstellbare Teil (12) mittels zumindest der periodischen und
spiegelsymmetrischen Verformungen der ersten mäanderförmigen Feder (16a) und der zweiten mäanderförmigen Feder (16b) in Bezug zu der Halterung (10) um die Drehachse (32) verstellbar ist,
wobei das mikromechanische Bauteil zumindest eine Sensoreinrichtung (44) umfasst, welche dazu ausgelegt ist, mindestens ein zu einer Auslenkung des verstellbaren Teils (12) aus seiner Ruhestellung in Bezug zu der Halterung (10) korrespondierendes Sensorsignal auszugeben oder bereitzustellen,
**dadurch gekennzeichnet, dass** die erste Torsionsfeder (26a) und die zweite Torsionsfeder (26b) an dem je einem äußeren Ende (28a, 28b) der jeweiligen Torsionsfeder direkt an der Halterung (10) angebunden sind, und
die Sensoreinrichtung (44) über mindestens eine an und/oder in der ersten Torsionsfeder (26a) und/oder der zweiten Torsionsfeder (26b) ausgebildete Signalleitung mit einer auf der Halterung (10) ausgebildeten Auswerteelektronik oder einem auf der Halterung (10) ausgebildeten Auswerteelektronik-Anbindungskontakt verbunden ist.

2. Mikromechanisches Bauteil nach Anspruch 1, wobei die erste Aktoreinrichtung (24a) und die zweite Aktoreinrichtung (24b) jeweils mehrere piezoelektrische Aktorschichten (24a, 24b) aus mindestens einem piezoelektrischen Material, welche an und/oder in mehreren Teilabschnitten (34a, 34b) der zugeordneten mäanderförmigen Feder (16a, 16b) ausgebildet sind, und jeweils mindestens eine elektrische Leitung, welche an und/oder in der zugeordneten mäanderförmigen Feder (16a, 16b) ausgebildet ist, so umfassen, dass mindestens ein Spannungssignal an die piezoelektrischen Aktorschichten (24a, 24b) der ersten mäanderförmigen Feder (16a) und der zweiten mäanderförmigen Feder (16b) derart anlegbar ist, dass die periodischen und spiegelsymmetrischen Verformungen der ersten mäanderförmigen Feder (16a) und der zweiten mäanderförmigen Feder (16b) bewirkbar sind.

3. Mikromechanisches Bauteil nach Anspruch 2, wobei jeweils zwei benachbarte mit piezoelektrischen Aktorschichten (24a) ausgebildete Teilabschnitte (34a, 34b) der ersten mäanderförmigen Feder (16a) über je einen Zwischenabschnitt (36) der ersten mäanderförmigen Feder (16a) und jeweils zwei benachbarte mit piezoelektrischen Aktorschichten (24b) ausgebildete Teilabschnitte (34a, 34b) der zweiten mäanderförmigen Feder (16b) über je einen Zwischenabschnitt (36) der zweiten mäanderförmigen Feder (16b) miteinander verbunden sind, und wobei mindestens einer der Zwischenabschnitte (36) der ersten mäanderförmigen Feder (16a) über je ein Stegelement (62) des mikromechanischen Bauteils mit dem dazu bezüglich der ersten Symmetrieebene (18) spiegelsymmetrischen Zwischenabschnitt (36) der zweiten mäanderförmigen Feder (16b) verbunden ist.

4. Mikromechanisches Bauteil nach Anspruch 2 oder 3, wobei die mit piezoelektrischen Aktorschichten (24a) ausgebildeten Teilabschnitte (34a, 34b) der ersten mäanderförmigen Feder (16a) und die mit piezoelektrischen Aktorschichten (24b) ausgebildeten Teilabschnitte (34a, 34b) der zweiten mäanderförmigen Feder (16b) parallel zueinander und senkrecht zu der Drehachse (32) ausgerichtet sind.

5. Mikromechanisches Bauteil nach Anspruch 4, wobei mindestens zwei benachbarte mit piezoelektrischen Aktorschichten (24a) ausgebildete Teilabschnitte (34a, 34b) der ersten mäanderförmigen Feder (16a) und mindestens zwei benachbarte mit piezoelektrischen Aktorschichten (24b) ausgebildete Teilabschnitte (34a, 34b) der zweiten mäanderförmigen Feder (16b) über je ein Zwischenfederelement (60) des mikromechanischen Bauteils miteinander verbunden sind.

6. Mikromechanisches Bauteil nach einem der vorhergehenden Ansprüche, wobei das mikromechanische Bauteil zusätzlich eine dritte mäanderförmige Feder (16c) und eine bezüglich der ersten Symmetrieebene (18) spiegelsymmetrisch zu der dritten mäanderförmigen Feder (16c) ausgebildete vierte mäanderförmige Feder (16b), welche an je einem äußeren Ende (20c, 20d) der jeweiligen mäanderförmigen Feder (16c, 16d) direkt oder indirekt an der Halterung (10) und an je einem inneren Ende (22c, 22d) der jeweiligen mäanderförmigen Feder (16c, 16d) direkt oder indirekt an dem verstellbaren Teil (12) angebunden sind, umfasst, und wobei an und/oder in der dritten mäanderförmigen Feder (16c) eine dritte Aktoreinrichtung (24c) und an und/oder in der vierten mäanderförmigen Feder (16d) eine vierte Aktoreinrichtung (24d) derart ausgebildet sind, dass mittels der dritten Aktoreinrichtung (24c) und der vierten Aktoreinrichtung (24d) periodische und bezüglich der ersten Symmetrieebene (18) spiegelsymmetrische Verformungen der dritten mäanderförmigen Feder (16c) und der vierten mäanderförmigen Feder (16d) anregbar sind, welche gegenphasig zu den periodischen und spiegelsymmetrischen Verformungen der ersten mäanderförmigen Feder (16a) und der zweiten mäanderförmigen Feder (16b) sind.

7. Mikromechanisches Bauteil nach Anspruch 6, wobei die dritte mäanderförmige Feder (16c) und die vierte mäanderförmige Feder (16d) bezüglich einer senkrecht zu der ersten Symmetrieebene (18) ausgerichteten zweiten Symmetrieebene spiegelsymmetrisch zu der ersten mäanderförmigen Feder (16a) und der zweiten mäanderförmigen Feder (16b) sind, und wobei die Drehachse (32) innerhalb der zweiten Symmetrieebene liegt.

8. Herstellungsverfahren für ein mikromechanisches Bauteil mit den Schritten:
Anbinden eines verstellbaren Teils (12) an eine Halterung (10) in Rahmenform über zumindest
eine erste mäanderförmige Feder (16a) und eine bezüglich einer ersten Symmetrieebene (18) spiegelsymmetrisch zu der ersten mäanderförmigen Feder (16a) ausgebildete zweite mäanderförmige Feder (16b), wobei je ein äußeres Ende (20a, 20b) der jeweiligen mäanderförmigen Feder (16a, 16b) direkt oder indirekt an der Halterung (10) und je ein inneres Ende (22a, 22b) der jeweiligen mäanderförmigen Feder (16a, 16b) direkt oder indirekt an dem verstellbaren Teil (12) angebunden werden (S1); und
Ausbilden einer ersten Aktoreinrichtung (24a) an und/oder in der ersten mäanderförmigen Feder (16a) und einer zweiten Aktoreinrichtung (24b) an und/oder in der zweiten mäanderförmigen Feder (16b) derart, dass mittels der ersten Aktoreinrichtung (24a) und der zweiten Aktoreinrichtung (24b) periodische und bezüglich der ersten Symmetrieebene (18) spiegelsymmetrische Verformungen der ersten mäanderförmigen Feder (16a) und der zweiten mäanderförmigen Feder (16b) anregbar sind, wodurch das verstellbare Teil (12) in Bezug zu der Halterung (10) verstellbar ist (S2);
Ausbilden einer ersten Torsionsfeder (26a) und einer zweiten Torsionsfeder (26b), welche sich jeweils entlang einer Drehachse (32) erstrecken, wobei je ein äußeres Ende (28a, 28b) der jeweiligen Torsionsfeder (26a, 26b) direkt an der Halterung (10) und je ein inneres Ende (30a, 30b) der jeweiligen Torsionsfeder (26a, 26b) direkt an dem verstellbaren Teil (12) so angebunden werden, dass das verstellbare Teil (12) mittels zumindest der periodischen und
spiegelsymmetrischen Verformungen der ersten mäanderförmigen Feder (16a) und der zweiten mäanderförmigen Feder (16b) in Bezug zu der Halterung (10) um die Drehachse (32) verstellbar ist (S3), und
Ausbilden einer Sensoreinrichtung (44) zum Bereitstellen oder Ausgeben mindestens eines zu einer Auslenkung des verstellbaren Teils (12) aus seiner Ruhestellung in Bezug zu der Halterung (10) korrespondierenden Sensorsignals (S4); und
Verbinden der Sensoreinrichtung (44) über mindestens eine an und/oder in der ersten Torsionsfeder (26a) und/oder der zweiten Torsionsfeder (26b) ausgebildete Signalleitung mit einer auf der Halterung (10) ausgebildeten Auswerteelektronik oder einem auf der Halterung (10) ausgebildeten Auswerteelektronik-Anbindungskontakt (S5).

## Claims

1. Micromechanical component comprising:
a mount (10) in the form of a frame;
a displaceable part (12); and
a first serpentine spring (16a) and a second serpentine spring (16b) formed mirror-symmetrically relative to the first serpentine spring (16a) with respect to a first plane of symmetry (18), which are each attached directly or indirectly to the mount (10) at a respective outer end (20a, 20b) of the respective serpentine spring (16a, 16b) and are each attached directly or indirectly to the displaceable part (12) at a respective inner end (22a, 22b) of the respective serpentine spring (16a, 16b);
wherein a first actuator device (24a) is formed on and/or in the first serpentine spring (16a) and a second actuator device (24b) is formed on and/or in the second serpentine spring (16b) in such a way that, by means of the first actuator device (24a) and the second actuator device (24b), it is possible to excite deformations of the first serpentine spring (16a) and of the second serpentine spring (16b) which are periodic and mirror-symmetrical with respect to the first plane of symmetry (18), as a result of which the displaceable part (12) is displaceable in relation to the mount (10);
a first torsion spring (26a) and a second torsion spring (26b), which each extend along an axis of rotation (32) and are each attached to the mount (10) at a respective outer end (28a, 28b) of the respective torsion spring (26a, 26b) and are each attached directly to the displaceable part (12) at a respective inner end (30a, 30b) of the respective torsion spring (26a, 26b),
wherein the displaceable part (12) is displaceable in relation to the mount (10) about the axis of rotation (32) by means of at least the periodic and mirror-symmetrical deformations of the first serpentine spring (16a) and the second serpentine spring (16b),
wherein the micromechanical component comprises at least one sensor device (44), which is designed to output or provide at least one sensor signal corresponding to a deflection of the displaceable part (12) out of its rest position in relation to the mount (10),
**characterized in that** the first torsion spring (26a) and the second torsion spring (26b) are each attached directly to the mount (10) at a respective outer end (28a, 28b) of the respective torsion spring, and
the sensor device (44) is connected via at least one signal line formed on and/or in the first torsion spring (26a) and/or the second torsion spring (26b) to evaluation electronics formed on the mount (10) or to an evaluation electronics connection contact formed on the mount (10).

2. Micromechanical component according to Claim 1, wherein the first actuator device (24a) and the second actuator device (24b) each comprise a plurality of piezoelectric actuator layers (24a, 24b) made of at least one piezoelectric material, which are formed on and/or in a plurality of portions (34a, 34b) of the associated serpentine spring (16a, 16b), and each comprise at least one electric line, which is formed on and/or in the associated serpentine spring (16a, 16b), such that at least one voltage signal can be applied to the piezoelectric actuator layers (24a, 24b) of the first serpentine spring (16a) and the second serpentine spring (16b) in such a way that the periodic and mirror-symmetrical deformations of the first serpentine spring (16a) and the second serpentine spring (16b) can be produced.

3. Micromechanical component according to Claim 2, wherein respectively two adjacent portions (34a, 34b) of the first serpentine spring (16a), formed with piezoelectric actuator layers (24a), are connected to one another via a respective intermediate section (36) of the first serpentine spring (16a), and respectively two adjacent portions (34a, 34b) of the second serpentine spring (16b), formed with piezoelectric actuator layers (24b), are connected to one another via a respective intermediate section (36) of the second serpentine spring (16b), and wherein at least one of the intermediate sections (36) of the first serpentine spring (16a) is connected via a respective web element (62) of the micromechanical component to the intermediate section (36) of the second serpentine spring (16b) which is mirror-symmetrical thereto with respect to the first plane of symmetry (18).

4. Micromechanical component according to Claim 2 or 3, wherein the portions (34a, 34b) of the first serpentine spring (16a) that are formed with piezoelectric actuator layers (24a), and the portions (34a, 34b) of the second serpentine spring (16b) that are formed with piezoelectric actuator layers (24b) are aligned parallel to each other and perpendicular to the axis of rotation (32).

5. Micromechanical component according to Claim 4, wherein at least two adjacent portions (34a, 34b) of the first serpentine spring (16a) that are formed with piezoelectric actuator layers (24a), and at least two adjacent portions (34a, 34b) of the second serpentine spring (16b) that are formed with piezoelectric actuator layers (24b) are connected to each other via a respective intermediate spring element (60) of the micromechanical component.

6. Micromechanical component according to one of the preceding claims, wherein the micromechanical component additionally comprises a third serpentine spring (16c) and a fourth serpentine spring (16b) formed mirror-symmetrically relative to the third serpentine spring (16c) with respect to the first plane of symmetry (18), which are each attached directly or indirectly to the mount (10) at a respective outer end (20c, 20d) of the respective serpentine spring (16c, 16d) and are each attached directly or indirectly to the displaceable part (12) at a respective inner end (22c, 22d) of the respective serpentine spring (16c, 16d), and wherein a third actuator device (24c) is formed on and/or in the third serpentine spring (16c) and a fourth actuator device (24d) is formed on and/or in the fourth serpentine spring (16d) in such a way that, by means of the third actuator device (24c) and the fourth actuator device (24d), it is possible to excite deformations of the third serpentine spring (16c) and of the fourth serpentine spring (16d) which are periodic and mirror-symmetrical with respect to the first plane of symmetry (18) and which are in anti-phase relative to the periodic and mirror-symmetrical deformations of the first serpentine spring (16a) and the second serpentine spring (16b).

7. Micromechanical component according to Claim 6, wherein, with respect to a second plane of symmetry aligned perpendicularly relative to the first plane of symmetry (18), the third serpentine spring (16c) and the fourth serpentine spring (16d) are mirror-symmetrical relative to the first serpentine spring (16a) and the second serpentine spring (16b), and wherein the axis of rotation (32) is located within the second plane of symmetry.

8. Production method for a micromechanical component, having the steps:
attaching a displaceable part (12) to a mount (10) in the form of a frame via at least a first serpentine spring (16a) and a second serpentine spring (16b) formed mirror-symmetrically relative to the first serpentine spring (16a) with respect to a first plane of symmetry (18), wherein an outer end (20a, 20b) of the respective serpentine spring (16a, 16b) is each attached directly or indirectly to the mount (10) and an inner end (22a, 22b) of the respective serpentine spring (16a, 16b) is each attached directly or indirectly to the displaceable part (12) (S1); and
forming a first actuator device (24a) on and/or in the first serpentine spring (16a) and a second actuator device (24b) on and/or in the second serpentine spring (16b) in such a way that, by means of the first actuator device (24a) and the second actuator device (24b), it is possible to excite deformations of the first serpentine spring (16a) and of the second serpentine spring (16b) which are periodic and mirror-symmetrical with respect to the first plane of symmetry (18), as a result of which the displaceable part (12) is displaceable in relation to the mount (10) (S2);
forming a first torsion spring (26a) and a second torsion spring (26b), which each extend along an axis of rotation (32), wherein an outer end (28a, 28b) of the respective torsion spring (26a, 26b) is each attached directly to the mount (10) and an inner end (30a, 30b) of the respective torsion spring (26a, 26b) is each attached directly to the displaceable part (12), such that the displaceable part (12) is displaceable in relation to the mount (10) about the axis of rotation (32) by means of at least the periodic and mirror-symmetrical deformations of the first serpentine spring (16a) and the second serpentine spring (16b) (S3), and
forming a sensor device (44) for providing or outputting at least one sensor signal corresponding to a deflection of the displaceable part (12) out of its rest position in relation to the mount (10) (S4); and
connecting the sensor device (44) via at least one signal line formed on and/or in the first torsion spring (26a) and/or the second torsion spring (26b) to evaluation electronics formed on the mount (10) or to an evaluation electronics connection contact formed on the mount (10) (S5) .

## Revendications

1. Composant micromécanique comprenant :
un support (10) en forme de cadre ;
une partie réglable (12) ; et
un premier ressort (16a) en forme de méandres et un deuxième ressort (16b) en forme de méandres, symétrique au premier ressort (16a) en forme de méandres par rapport à un premier plan de symétrie (18), qui sont fixés chacun à une extrémité extérieure (20a, 20b) de chaque ressort (16a, 16b) en forme de méandres directement ou indirectement au support (10) et à une extrémité intérieure (22a, 22b) de chaque ressort (16a, 16b) en forme de méandres sont reliés directement ou indirectement à la partie réglable (12) ;
un premier dispositif d'actionnement (24a) étant réalisé sur et/ou dans le premier ressort (16a) en forme de méandres et un deuxième dispositif d'actionnement (24b) étant réalisé sur et/ou dans le deuxième ressort (16b) en forme de méandres de telle sorte, qu'au moyen du premier dispositif d'actionnement (24a) et du deuxième dispositif d'actionnement (24b), des déformations périodiques et symétriques par rapport au premier plan de symétrie (18) du premier ressort (16a) en forme de méandres et du deuxième ressort (16b) en forme de méandres sont aptes à être excitées, ce qui permet de régler la pièce réglable (12) par rapport au support (10) ;
un premier ressort de torsion (26a) et un deuxième ressort de torsion (26b), qui s'étendent chacun le long d'un axe de rotation (32) et sont reliés chacun à une extrémité extérieure (28a, 28b) du ressort de torsion respectif (26a, 26b) au support (10) et à une extrémité intérieure (30a, 30b) du ressort de torsion respectif (26a, 26b) directement à la partie réglable (12),
la partie réglable (12) étant réglable autour de l'axe de rotation (32) au moyen d'au moins les déformations périodiques et symétriques du premier ressort (16a) en forme de méandres et du deuxième ressort (16b) en forme de méandres par rapport au support (10),
le composant micromécanique comprenant au moins un dispositif de détection (44) qui est conçu pour émettre ou mettre à disposition au moins un signal de détection correspondant à une déviation de la partie réglable (12) à partir de sa position de repos par rapport au support (10),
**caractérisé en ce que** le premier ressort de torsion (26a) et le deuxième ressort de torsion (26b) sont reliés directement au support (10) à l'extrémité extérieure respective (28a, 28b) du ressort de torsion respectif, et
le dispositif de détection (44) est relié par au moins une ligne de signal formée sur et/ou dans le premier ressort de torsion (26a) et/ou le deuxième ressort de torsion (26b) à une électronique d'évaluation formée sur le support (10) ou à un contact de connexion d'électronique d'évaluation formé sur le support (10).

2. Composant micromécanique selon la revendication 1, dans lequel le premier dispositif d'actionnement (24a) et le deuxième dispositif d'actionnement (24b) comportent chacun plusieurs couches d'actionnement piézoélectriques (24a, 24b) en au moins un matériau piézoélectrique, qui sont formées sur et/ou dans plusieurs sections partielles (34a, 34b) du ressort (16a, 16b) en forme de méandres associé, et au moins une ligne électrique respective, qui est formée sur et/ou dans le ressort (16a, 16b) en forme de méandres associé, de telle sorte qu'au moins un signal de tension peut être appliqué aux couches d'actionneur piézoélectriques (24a, 24b) du premier ressort (16a) en forme de méandres et du deuxième ressort en forme de méandres (16b) de telle sorte que les déformations périodiques et symétriques en miroir du premier ressort (16a) en forme de méandres et du deuxième ressort en forme de méandres (16b) sont aptes à être provoquées.

3. Composant micromécanique selon la revendication 2, dans lequel respectivement deux sections partielles voisines (34a, 34b) du premier ressort (16a) en forme de méandres, réalisées avec des couches d'actionneur piézoélectriques (24a), sont reliées chacune par une section intermédiaire (36) du premier ressort (16a) en forme de méandres et respectivement deux sections partielles voisines (34a, 34b) réalisées avec des couches d'actionneur piézoélectriques (24b) du deuxième ressort (16b) en forme de méandres sont reliées entre elles par l'intermédiaire d'une section intermédiaire (36) respective du deuxième ressort (16b) en forme de méandres, et au moins l'une des sections intermédiaires (36) du premier ressort (16a) en forme de méandres étant reliée par l'intermédiaire d'un élément formant entretoise (62) respectif du composant micromécanique à la section intermédiaire (36) du deuxième ressort (16b) en forme de méandres, qui est symétrique par rapport au premier plan de symétrie (18).

4. Composant micromécanique selon la revendication 2 ou 3, dans lequel les sections partielles (34a, 34b) du premier ressort (16a) en forme de méandres réalisées avec des couches d'actionneurs piézoélectriques (24a) et les sections partielles (34a, 34b) du deuxième ressort (16b) en forme de méandres réalisées avec des couches d'actionneurs piézoélectriques (24b) sont orientées parallèlement entre elles et perpendiculairement à l'axe de rotation (32).

5. Composant micromécanique selon la revendication 4, dans lequel au moins deux sections partielles (34a, 34b) voisines, réalisées avec des couches d'actionneur piézoélectriques (24a), du premier ressort (16a) en forme de méandres et au moins deux sections partielles (34a, 34b) voisines, réalisées avec des couches d'actionneur piézoélectriques (24b), du deuxième ressort (16b) en forme de méandres sont reliées entre elles chacune par un élément de ressort intermédiaire (60) du composant micromécanique.

6. Composant micromécanique selon l'une des revendications précédentes, le composant micromécanique comprenant en outre un troisième ressort (16c) en forme de méandres et un quatrième ressort (16b) en forme de méandres symétrique au troisième ressort (16c) en forme de méandres par rapport au premier plan de symétrie (18), qui sont reliés à une extrémité extérieure (20c, 20d) de chaque ressort (16c, 16d) en forme de méandres directement ou indirectement à la support (10) et à une extrémité intérieure (22c, 22d) de chaque ressort en forme de méandres (16c, 16d) directement ou indirectement à la partie réglable (12), et un troisième dispositif d'actionnement (24c) étant réalisé sur et/ou dans le troisième ressort (16c) en forme de méandres et un quatrième dispositif d'actionnement (24d) étant réalisé sur et/ou dans le quatrième ressort (16d) en forme de méandres de telle sorte, qu'au moyen du troisième dispositif d'actionnement (24c) et du quatrième dispositif d'actionnement (24d), des déformations périodiques et symétriques par rapport au premier plan de symétrie (18) du troisième ressort (16c) en forme de méandres et du quatrième ressort (16d) en forme de méandres sont aptes à être excitées, lesquelles sont en opposition de phase avec les déformations périodiques et symétriques du premier ressort (16a) en forme de méandres et du deuxième ressort (16b) en forme de méandres.

7. Composant micromécanique selon la revendication 6, dans lequel le troisième ressort (16c) en forme de méandres et le quatrième ressort (16d) en forme de méandres sont symétriques par rapport au premier ressort (16a) en forme de méandres et au deuxième ressort en forme de méandres (16b) par rapport à un deuxième plan de symétrie orienté perpendiculairement au premier plan de symétrie (18), et dans lequel l'axe de rotation (32) est situé à l'intérieur du deuxième plan de symétrie.

8. Procédé de fabrication d'un composant micromécanique comprenant les étapes suivantes :
relier une pièce réglable (12) à un support (10) en forme de cadre par l'intermédiaire d'au moins un premier ressort (16a) en forme de méandres et d'un deuxième ressort (16b) en forme de méandres réalisé de manière symétrique par rapport à un premier plan de symétrie (18) par rapport au premier ressort (16a) en forme de méandres, une extrémité extérieure (20a, 20b) de chaque ressort (16a, 16b) en forme de méandres étant reliée (S1) directement ou indirectement au support (10) et une extrémité intérieure (22a, 22b) de chaque ressort (16a, 16b) en forme de méandres étant reliée (S1) directement ou indirectement à la partie réglable (12) ; et
former un premier dispositif d'actionnement (24a) sur et/ou dans le premier ressort (16a) en forme de méandres et un deuxième dispositif d'actionnement (24b) sur et/ou dans le deuxième ressort (16b) en forme de méandres de telle manière qu'au moyen du premier dispositif d'actionnement (24a) et du deuxième dispositif d'actionnement (24b), des déformations périodiques et symétriques par rapport au premier plan de symétrie (18) du premier ressort (16a) en forme de méandres et du deuxième ressort (16b) en forme de méandres sont aptes à être excitées, ce qui permet de régler (S2) la pièce réglable (12) par rapport au support (10) ;
former un premier ressort de torsion (26a) et un deuxième ressort de torsion (26b), qui s'étendent chacun le long d'un axe de rotation (32), une extrémité extérieure (28a, 28b) de chaque ressort de torsion (26a, 26b) étant directement fixée au support (10) et une extrémité intérieure (30a, 30b) de chaque ressort de torsion (26a, 26b) directement à la partie réglable (12) de telle sorte que la partie réglable (12) puisse être réglée (S3) autour de l'axe de rotation (32) au moyen d'au moins les déformations périodiques et symétriques du premier ressort (16a) en forme de méandres et du deuxième ressort (16b) en forme de méandres par rapport au support (10), et
former un dispositif de détection (44) pour fournir ou émettre au moins un signal de détection (S4) correspondant à une déviation de la partie réglable (12) à partir de sa position de repos par rapport au support (10) ; et
relier le dispositif de détection (44) par l'intermédiaire d'au moins une ligne de signal formée sur et/ou dans le premier ressort de torsion (26a) et/ou le deuxième ressort de torsion (26b) à une électronique d'évaluation formée sur le support (10) ou à un contact de liaison d'électronique d'évaluation (S5) formé sur le support (10).
